# FASCICULE DE BREVET EUROPEEN

(11) **EP 2 723 605 B1**
(45) Date de publication et mention de la délivrance du brevet: **12.08.2015**
(21) Numéro de dépôt: 12730827.8
(22) Date de dépôt: 12.06.2012
(51) Int. Cl.: B60K 37/06, B60Q 3/00, B60Q 3/04, G01L 1/00, G01L 1/20, H03K 17/96

(54) **PANNEAU DE COMMANDE COMPORTANT UNE TOUCHE RETRO-ECLAIREE DE TYPE RESISTIVE**
STEUERTAFEL MIT EINER RESISTIVEN HINTERGRUNDBELEUCHTETEN TASTE
CONTROL PANEL COMPRISING A RESISTIVE-TYPE BACKLIT KEY

(30) Priorité: 23.06.2011 FR 1155531
(43) Date de publication de la demande: 30.04.2014
(73) Titulaire: Delphi Technologies, Inc., Troy, MI 48007 (US)
(72) Inventeur: GEYL, Laurent, F-67000 STRASBOURG (FR); JANY, Eric, F-67400 Illkirch (FR)
(74) Mandataire: Delphi France SAS
(86) Numéro de dépôt international: PCT/EP2012/061080
(87) Numéro de publication internationale: WO 2012/175369

(56) Documents cités:
- EP-A1- 0 489 344
- DE-A1-102008 055 865

## Description

### DOMAINE TECHNIQUE

La présente invention concerne un panneau de commande, notamment pour un véhicule automobile, comportant une touche rétro-éclairée résistive

### ARRIERE-PLAN TECHNOLOGIQUE DE L'INVENTION

La présente invention concerne plus particulièrement un panneau de commande destiné à être agencé dans l'habitacle d'un véhicule automobile, notamment au tableau de bord, et qui comporte au moins un bouton de commande sous la forme d'une touche résistive prévu pour commander une fonction déterminée, par exemple pour commander la mise en marche ou l'arrêt de la fonction air conditionné.

Le panneau de commande comporte un capot qui est monté sur un support et qui est muni d'au moins une zone de détection prévue pour former un bouton de commande. Un capteur d'effort, ou capteur tactile, est agencé entre le capot et le support, à l'arrière de la zone de détection, de manière à produire un signal électrique de commande lorsqu'un utilisateur exerce une force d'appui suffisante sur la zone de détection.

Généralement, les boutons de commande utilisés dans un véhicule automobile sont du type à bouton-poussoir, c'est-à-dire qu'ils comportent un dispositif de commutation électrique actionné par un organe de commande mécanique. Chaque bouton, du fait de sa cinématique dédiée, est unitairement apparent sur la façade et ce de façon visuelle et tactile. Pour permettre une bonne identification des fonctions associées à chaque bouton de commande, il est connu de munir chaque bouton-poussoir d'un symbole rétro-éclairé agencé sur l'organe de commande mécanique. A cet effet, une portion du bouton-poussoir comporte une zone translucide de la forme du symbole et une source lumineuse est agencée à l'arrière du bouton-poussoir, dans le panneau de commande, de manière à émettre un faisceau de rétro-éclairage vers le symbole.

Ce type de rétro-éclairage n'est pas transposable au cas d'un panneau de commande à touche résistive du fait de la présence du capteur d'effort sous la zone d'appui à l'arrière du capot.

Un panneau de commande comportant les caractéristiques du preambule de la revendication 1 est connu du document DE 10 2008 055865 A1.

### RESUME DE L'INVENTION

La présente invention vise à proposer une solution simple, efficace, et économique pour permettre le rétro-éclairage d'un symbole situé sur la touche résistive, dans la zone de détection de l'appui tactile.

Dans ce but, l'invention propose un panneau de commande, notamment pour un véhicule automobile, comportant un capot qui est muni d'au moins une zone de détection d'un appui tactile formant bouton de commande, dans lequel un capteur d'effort est agencé entre le capot et un support, à l'arrière de la zone de détection, de manière à détecter l'actionnement du bouton de commande pour produire un signal électrique de commande lorsqu'un utilisateur exerce une force d'appui tactile déterminée sur la zone de détection, dans lequel une entretoise en matériau compressible élastiquement est montée entre le capteur et le capot de manière à rattraper les jeux mécaniques entre le capteur et le capot, caractérisé en ce que l'entretoise est au moins partiellement translucide et en ce que le panneau de commande comporte au moins une source lumineuse principale et un collecteur de lumière qui permet d'injecter la lumière produite par ladite source lumineuse principale dans l'épaisseur de l'entretoise de manière que l'entretoise produise un faisceau de rétro-éclairage dirigé vers une zone à illuminer de la zone de détection, la source lumineuse principale étant agencée sur une plaque à circuits imprimés qui est fixée à l'arrière du support, du côté opposé au capteur d'effort, une portion du collecteur s'étendant dans un trou traversant aménagé dans l'épaisseur du support en regard de la source lumineuse principale.

L'invention permet d'obtenir un panneau de commande avec des touches résistives rétro-éclairées dans un encombrement réduit et en utilisant un minimum de pièces ce qui facilite les opérations d'assemblage, autorise des styles de façade plus variés et réduit les coûts d'intégration. Elle permet d'utiliser un capteur d'effort tel qu'un capteur résistif du type FSR (Force Sensing Resistor) sans avoir à utiliser des encres transparentes, non adaptées à des applications automobiles, pour les pistes conductrices tout en garantissant une grande fiabilité du panneau de commande. Grâce à l'invention la zone à illuminer peut s'étendre si besoin sur toute la surface en regard du capteur d'effort ce qui offre une plus grande liberté dans la définition des pictogrammes du panneau de commande tant sur le contenu informatif que sur le style

Selon d'autres caractéristiques avantageuses de l'invention :
- la zone à illuminer est agencée en vis-à-vis de la zone sensible à la pression du capteur d'effort et la source lumineuse principale est déportée transversalement par rapport à la zone à illuminer ;
- le collecteur de lumière est connecté au bord périphérique de l'entretoise de manière que la lumière émise par la source lumineuse principale pénètre dans l'épaisseur de l'entretoise ;
- le collecteur est constitué par une pièce rapportée qui est interposée entre la source lumineuse principale et l'entretoise ;
- le collecteur est réalisé d'une seule pièce avec l'entretoise ;
- l'entretoise est entièrement réalisée en matériau translucide, par exemple du type silicone ;
- un témoin lumineux est associé à la zone de détection et est prévu pour être rétro-éclairé par une source lumineuse auxiliaire à travers le capteur, la zone sensible du capteur délimitant une zone de passage de la lumière permettant le rétro-éclairage du témoin lumineux ;
- le capteur d'effort comporte un premier et un second substrats dont l'un au moins est flexible lorsqu'une force d'appui tactile est exercée sur la zone de détection, des pistes conductrices et un revêtement résistif étant agencés entre les deux substrats de manière à définir une zone sensible à la pression qui permet au capteur de détecter la force d'appui tactile par une variation de la résistance électrique entre les pistes conductrices à travers le revêtement résistif pour produire le signal de commande ;
- le capteur est du type précontraint, le revêtement résistif étant prévu pour être en contact électrique avec les pistes conductrices y compris en l'absence d'appui tactile, la précontrainte étant assurée par l'entretoise ;
- le panneau de commande comporte plusieurs zones de détection formant plusieurs boutons de commande associés à plusieurs capteurs d'effort, en ce que les entretoises associées aux différentes zones de détection sont réalisées d'une seule pièce les unes avec les autres pour former une plaque, et la source lumineuse principale éclaire plusieurs entretoises de la plaque ;
- la source lumineuse principale est prévue pour émettre la lumière selon au moins deux couleurs distinctes de manière à permettre d'identifier l'état activé et l'état désactivé du bouton de commande associé ;
- la zone à illuminer de la zone de détection est constituée par un symbole translucide dessiné sur le capot.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- la figure 1 est un schéma qui représente vu de dessus un panneau de commande comportant une touche résistive munie d'un symbole rétro-éclairé réalisé conformément aux enseignements de l'invention ;
- la figure 2 est une vue en coupe axiale 2-2 qui représente schématiquement le panneau de commande de la figure 1 ;
- la figure 3 est une vue de face qui représente schématiquement un film portant un capteur d'effort prévu pour permettre la détection d'appui tactile sur la touche résistive du panneau de la figure 1 ;
- la figure 4 est une vue partielle en coupe axiale 2-2 qui représente schématiquement la structure du capteur d'effort de la figure 3.

### DESCRIPTION DES MODES DE REALISATION PREFERES

Dans la suite de la description, des éléments identiques ou similaires pourront être désignés par des références identiques.

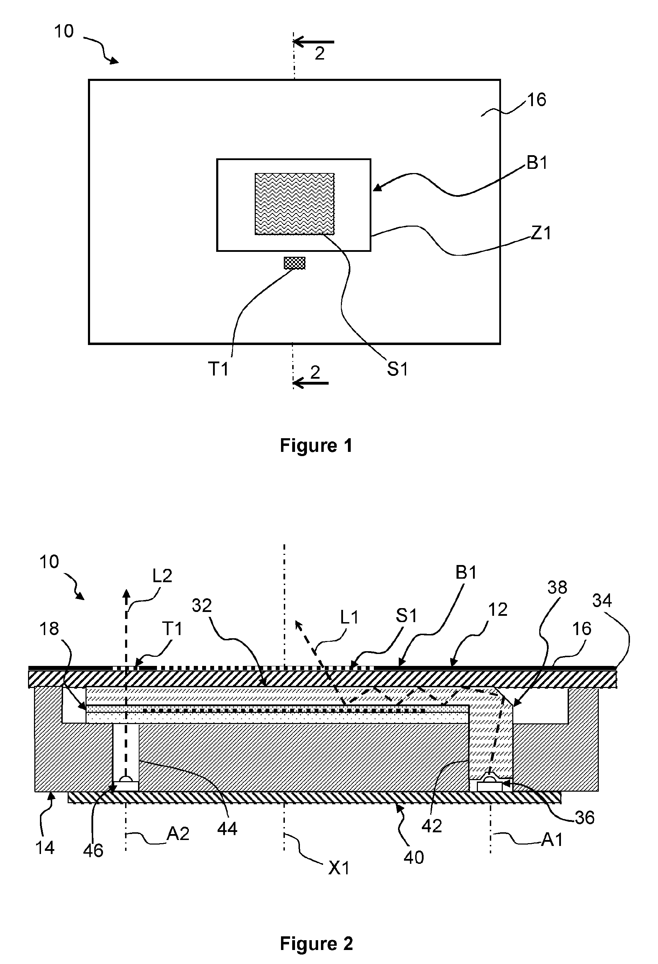

Sur les figures 1 et 2, on a représenté un panneau de commande 10 pour un tableau de bord de véhicule automobile réalisé conformément aux enseignements de l'invention. Le panneau de commande 10 comporte un capot 12 dont la surface extérieure 16 est munie d'une zone de détection Z1 d'un appui tactile formant un bouton de commande B1, ou touche résistive.

Dans la suite de la description, on utilisera à titre non limitatif une orientation axiale suivant un axe X1 sensiblement orthogonal au plan général du capot 12, orienté de l'avant vers l'arrière, ce qui correspond globalement à une orientation du haut vers le bas en considérant la figure 2.

Le bouton de commande B1 comporte un capteur d'effort 18 qui est monté entre le capot 12 et un support 14 fixé à l'arrière du capot 12. Le capteur d'effort 18 est agencé axialement en vis-à-vis de la zone de détection Z1 d'appui tactile, en vue de permettre la détection de l'actionnement du bouton de commande B1 et l'émission d'un signal électrique de commande lorsqu'un utilisateur exerce une force d'appui tactile d'intensité suffisante sur la zone de détection Z1.

Selon une caractéristique avantageuse de l'invention, le capteur d'effort 18 est du type à résistance variable en fonction de l'effort, par exemple du type FSR (Force Sensing Resistor) comme décrit et représenté dans les documents US2006/0007172A1 et WO2009/070503A1.

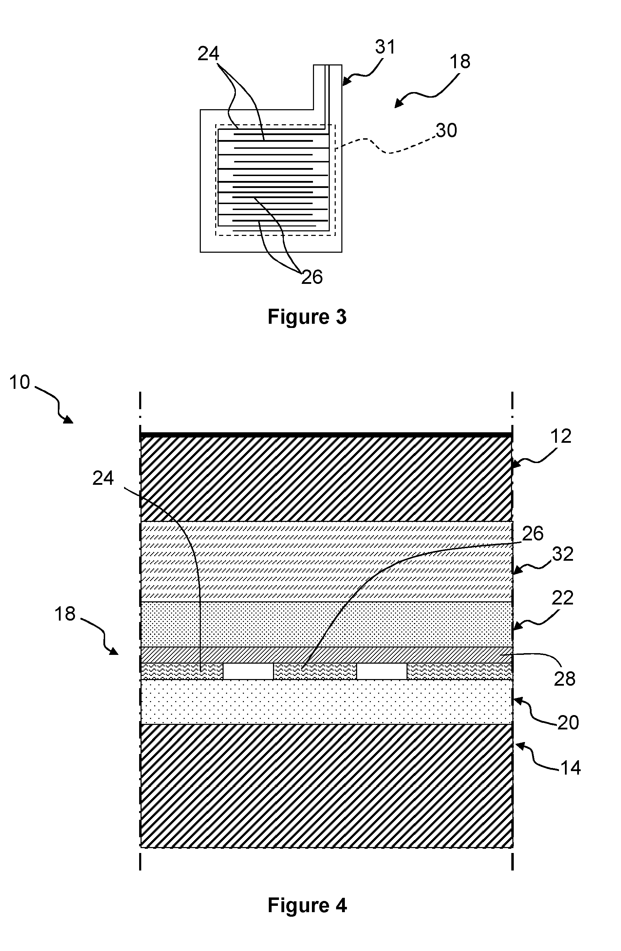

De préférence, on utilise ici un capteur d'effort 18 monté sous précontrainte mécanique, comme on l'a représenté sur les figures 3 et 4. Le capteur d'effort 18 comporte ici un premier 20 et un second 22 substrats dont l'un au moins est flexible lorsqu'une force d'appui tactile est exercée sur la zone de détection Z1. Des pistes conductrices électriques 24, 26 sont agencées, ici sous forme de peignes interdigités comme illustré par la figure 3, sur la face avant du premier substrat 20 en vis-à-vis d'un revêtement résistif 28 agencé sur la face arrière du second substrat 22, de manière à définir une zone sensible à la pression 30 qui est globalement superposée à la zone de détection Z1. A l'état de repos du capteur d'effort 18, en l'absence de force d'appui tactile, le revêtement résistif 28 est en contact électrique avec des portions de pistes conductrices 24, 26.

Comme représenté sur la figure 3, le capteur d'effort 18 se présente ici sous la forme d'un film comportant une languette de raccordement électrique 31 munie de moyens de raccordement électrique permettant la connexion des pistes conductrices 24, 26 à un circuit électronique de commande (non représenté).

Une entretoise 32 en matériau translucide et compressible élastiquement est montée entre le capteur 18 et le capot 12, de manière à rattraper les jeux mécaniques entre le capteur 18 et le capot 12. L'entretoise 32 permet aussi de maintenir un effort de précontrainte sur le capteur 18 y compris en l'absence d'appui tactile sur la zone de détection Z1.

On note que, du fait de la rigidité du capot 12 au niveau de la zone de détection Z1, les jeux de fonctionnement, c'est-à-dire les déplacements axiaux du capot 12 au niveau de la zone de détection Z1, peuvent être inférieurs aux jeux mécaniques. L'entretoise 32 permet donc de rattraper les jeux mécaniques pour permettre la détection des déplacements axiaux X1 du capot 12 dus à des appuis tactiles.

L'entretoise 32 est par exemple réalisée par moulage sous la forme d'une plaquette en silicone.

La zone de détection Z1 du panneau de commande 10 comporte une zone à illuminer constituée ici par un symbole S1 prévu pour être rétro-éclairé. Le symbole SI est formé par exemple à la surface du capot 12 par grattage laser en enlevant localement une couche du revêtement extérieur opaque 34 du capot 12, le matériau constituant le capot 12 étant sensiblement translucide sous ce revêtement 34.

Selon le mode de réalisation représenté ici, un témoin lumineux T1, prévu pour être rétro-éclairé, est agencé à proximité de la zone de détection Z1. Le témoin lumineux T1 peut être formé par exemple de la même manière que le symbole SI, par grattage laser, et il vise à donner à l'utilisateur une indication sur l'état d'activation ou de non activation du dispositif lié à l'actionnement du bouton B1, par exemple l'enclenchement de l'air conditionné.

Conformément aux enseignements de l'invention, le panneau de commande 10 est équipé d'une source lumineuse principale 36 et d'un collecteur de lumière 38 prévu pour injecter la lumière émise par la source principale 36 dans l'épaisseur de l'entretoise 32 de manière que l'entretoise 32 produise un faisceau de rétro-éclairage L1 dirigé vers une zone à illuminer constituée ici par le symbole SI. Avantageusement, la source lumineuse principale 36, constituée ici par une diode électroluminescente, est déportée transversalement par rapport au symbole SI et par rapport au capteur d'effort 18. La direction axiale A1 de l'éclairage principal est donc déportée transversalement en dehors de la zone sensible à la pression 30 du capteur d'effort 18.

Le collecteur de lumière 38 forme ici un bras qui s'étend axialement vers l'arrière, depuis le bord périphérique de l'entretoise 32 jusqu'à la source lumineuse principale 36. Le collecteur de lumière 38 est donc connecté au bord périphérique de l'entretoise 32, soit en étant adjacent à ce bord périphérique, soit en étant réalisé d'une seule pièce avec l'entretoise 32, comme c'est le cas sur la figure 2. Le collecteur de lumière 38 est par exemple moulé dans le même matériau translucide que l'entretoise 32, ou bien il est surmoulé avec l'entretoise 32 dans un matériau translucide différent.

L'entretoise 32 est donc utilisée, en plus de sa fonction de rattrapage des jeux mécaniques, comme guide de lumière pour le rétro-éclairage du symbole SI. L'entretoise 32 peut être munie sur au moins une de ses faces principales d'éléments optiques réfractifs visant à amplifier la diffusion de la lumière provenant de la source lumineuse principale 36 dans des zones situées en regard du symbole SI. Ces éléments optiques réfractifs sont constitués par exemple par des structures en relief telles que des rainures ou des nervures.

Selon le mode de réalisation représenté sur la figure 2, la source lumineuse principale 36 est montée sur la face avant d'une plaque à circuits imprimés 40 qui est elle-même fixée sur la face arrière du support 14. De préférence, cette plaque à circuits imprimés 40 comporte un circuit électronique qui commande le capteur d'effort 18 et la source lumineuse principale 36.

Le support 14 comporte ici un trou traversant principal 42 en vis-à-vis de la source lumineuse principale 36 et le collecteur de lumière 38 s'étend au moins partiellement à l'intérieur de ce trou traversant principal 42. Le collecteur de lumière 38 possède avantageusement une section transversale sensiblement complémentaire du trou traversant principal 42 ce qui permet l'insertion axiale du collecteur de lumière 38 dans le support 14, notamment pour aider au positionnement relatif de l'entretoise 32 par rapport au support 14.

Selon le mode de réalisation représenté, un trou traversant auxiliaire 44 est aménagé dans le support 14, au droit du témoin lumineux T1 et au droit d'une source lumineuse auxiliaire 46 montée sur la face avant de la plaque à circuits imprimés 40 en vue d'assurer le rétro-éclairage L2 du témoin lumineux T1. La direction axiale A2 de l'éclairage auxiliaire est ici alignée avec le témoin lumineux T1 et déportée transversalement en dehors de la zone sensible à la pression 30 du capteur d'effort 18.

Selon une variante de réalisation, la source lumineuse principale 36 peut être prévue pour émettre la lumière L1 dans au moins deux couleurs différentes ce qui peut permettre d'identifier l'état activé ou désactivé de la fonction associée sans recourir à un témoin lumineux T1 auxiliaire.

Selon une variante de réalisation (non représentée), plusieurs boutons de commande B1 peuvent être positionnés de manière sensiblement adjacente sur le capot 12, les capteurs d'effort 18 associés étant alors agencés sur un même film comportant les substrats 20, 22. Dans une telle variante, le panneau de commande 10 peut comporter autant de sources lumineuses principales 36 et de collecteurs de lumière 38 que le nombre de boutons de commande B1, ou bien il peut comporter une source lumineuse principale 36 et un collecteur de lumière 38 communs à plusieurs boutons de commande B1.

La plaque à circuit imprimé 40 peut être de type rigide ou flexible. Dans ce dernier cas la source lumineuse 36 et le capteur d'effort 18 font partie intégrante d'un seul circuit imprimé flexible ce qui réduit le nombre de pièce.

## Revendications

1. Panneau de commande (10), notamment pour un véhicule automobile, comportant un capot (12) qui est muni d'au moins une zone de détection (Z1) d'un appui tactile formant bouton de commande (B1), dans lequel un capteur d'effort (18) est agencé entre le capot (12) et un support (14), à l'arrière de la zone de détection (Z1), de manière à détecter l'actionnement du bouton de commande (B1) pour produire un signal électrique de commande lorsqu'un utilisateur exerce une force d'appui tactile déterminée sur la zone de détection (Z1), dans lequel une entretoise (32) en matériau compressible élastiquement est montée entre le capteur (18) et le capot (12) de manière à rattraper les jeux mécaniques entre le capteur (18) et le capot (12), l'entretoise (32) étant au moins partiellement translucide et le panneau de commande (10) comportant au moins une source lumineuse principale (36) et un collecteur de lumière (38) qui permet d'injecter la lumière produite par ladite source lumineuse principale (36) dans l'épaisseur de l'entretoise (32) de manière que l'entretoise (32) produise un faisceau de rétro-éclairage dirigé vers une zone à illuminer (S1) de la zone de détection (Z1), la source lumineuse principale (36) étant agencée sur une plaque à circuits imprimés (40) qui est fixée à l'arrière du support (14), du côté opposé au capteur d'effort (18), **caractérisée en ce qu'** une portion du collecteur (38) s' étend dans un trou traversant (42) aménagé dans l'épaisseur du support (14) en regard de la source lumineuse principale (36).

2. Panneau de commande (10) selon la revendication précédente, **caractérisé en ce que** la zone à illuminer (S1) est agencée en vis-à-vis de la zone sensible à la pression (30) du capteur d'effort (18) et **en ce que** la source lumineuse principale (36) est déportée transversalement par rapport à la zone à illuminer (S1).

3. Panneau de commande (10) selon l'une quelconque des revendications précédentes, **caractérisé en ce que** le collecteur de lumière (38) est connecté au bord périphérique de l'entretoise (32) de manière que la lumière émise par la source lumineuse principale (36) pénètre dans l'épaisseur de l'entretoise (32).

4. Panneau de commande (10) selon la revendication précédente, **caractérisé en ce que** le collecteur (38) est constitué par une pièce rapportée qui est interposée entre la source lumineuse principale (36) et l'entretoise (32).

5. Panneau de commande (10) selon la revendication 3, **caractérisé en ce que** le collecteur (38) est réalisé d'une seule pièce avec l'entretoise (32).

6. Panneau de commande (10) selon l'une quelconque des revendications précédentes, **caractérisé en ce que** l'entretoise (32) est entièrement réalisée en matériau translucide, par exemple du type silicone.

7. Panneau de commande (10) selon l'une quelconque des revendications précédentes, **caractérisé en ce qu'**un témoin lumineux (T1) est associé à la zone de détection (Z1) et est prévu pour être rétro-éclairé par une source lumineuse auxiliaire (46) à travers le capteur (18), la zone sensible (30) du capteur (18) délimitant une zone de passage de la lumière (32) permettant le rétro-éclairage du témoin lumineux.

8. Panneau de commande (10) selon l'une quelconque des revendications précédentes, **caractérisé en ce que** le capteur d'effort (18) comporte un premier (20) et un second (22) substrats dont l'un au moins est flexible lorsqu'une force d'appui tactile est exercée sur la zone de détection (Z1), des pistes conductrices (24, 26) et un revêtement résistif (28) étant agencés entre les deux substrats (20, 22) de manière à définir une zone sensible à la pression (30) qui permet au capteur (18) de détecter la force d'appui tactile par une variation de la résistance électrique entre les pistes conductrices (24, 26) à travers le revêtement résistif (28) pour produire le signal de commande.

9. Panneau de commande (10) selon la revendication précédente, **caractérisé en ce que** le capteur (18) est du type précontraint, le revêtement résistif (28) étant prévu pour être en contact électrique avec les pistes conductrices (24, 26) y compris en l'absence d'appui tactile, la précontrainte étant assurée par l'entretoise (32).

10. Panneau de commande (10) selon l'une quelconque des revendications précédentes, **caractérisé en ce qu'**il comporte plusieurs zones de détection (Z1) formant plusieurs boutons de commande (B1) associés à plusieurs capteurs d'effort (18), **en ce que** les entretoises (32) associées aux différentes zones de détection (Z1) sont réalisées d'une seule pièce les unes avec les autres pour former une plaque, et **en ce que** la source lumineuse principale (36) éclaire plusieurs entretoises (32) de la plaque.

11. Panneau de commande (10) selon l'une quelconque des revendications précédentes, **caractérisé en ce que** la source lumineuse principale (36) est prévue pour émettre la lumière selon au moins deux couleurs distinctes de manière à permettre d'identifier l'état activé et l'état désactivé du bouton de commande (B1) associé.

12. Panneau de commande (10) selon l'une quelconque des revendications précédentes, **caractérisé en ce que** la zone à illuminer (S1) de la zone de détection (Z1) est constituée par un symbole translucide dessiné sur le capot (12).

## Patentansprüche

1. Bedienfeld (10), insbesondere für ein Kraftfahrzeug, enthaltend eine Abdeckung (12), die mit zumindest einem Erfassungsbereich (Z1) zum Erfassen einer physischen Berührung ausgestattet ist, der eine Steuertaste (B1) darstellt, wobei ein Kraftsensor (18) zwischen der Abdeckung (12) und einem Träger (14) auf der Hinterseite des Erfassungsbereichs (Z1) so angeordnet ist, dass die Betätigung der Steuertaste (B1) erfasst wird, um ein elektrisches Steuersignal dann zu erzeugen, wenn ein Benutzer eine bestimmte Berührungskraft auf den Erfassungsbereich (Z1) ausübt, wobei eine Verstrebung (32) aus elastisch zusammendrückbarem Material zwischen dem Sensor (18) und der Abdeckung (12) so angeordnet ist, dass ein mechanisches Spiel zwischen dem Sensor (18) und der Abdeckung (12) ausgeglichen wird, wobei die Verstrebung (32) zumindest teilweise lichtdurchlässig ist und das Bedienfeld (10) zumindest eine Hauptlichtquelle (36) und einen Lichtkollektor (38) aufweist, über den das von der Hauptlichtquelle (36) erzeugte Licht in die Dicke der Verstrebung (32) so eingeleitet werden kann, dass die Verstrebung (32) einen Hinterleuchtungsstrahl erzeugt, der zu einem auszuleuchtenden Bereich (S 1) des Erfassungsbereichs (Z1) gerichtet ist, wobei die Hauptlichtquelle (36) an einer gedruckten Leiterplatte (40) angeordnet ist, die auf der Hinterseite des Trägers (14) auf der dem Kraftsensor (18) entgegengesetzten Seite befestigt ist, **dadurch gekennzeichnet, dass** ein Abschnitt des Kollektors (38) sich in einem durchgehenden Loch (42) erstreckt, das in der Dicke des Trägers (14) der Hauptlichtquelle (36) gegenüberliegend ausgeführt ist.

2. Bedienfeld (10) nach dem vorangehenden Anspruch, **dadurch gekennzeichnet, dass** der auszuleuchtende Bereich (S1) dem druckempfindlichen Bereich (30) des Kraftsensors (18) gegenüberliegend angeordnet ist und dass die Hauptlichtquelle (36) quer zum auszuleuchtenden Bereich (S1) versetzt ist.

3. Bedienfeld (10) nach einem der vorangehenden Ansprüche, **dadurch gekennzeichnet, dass** der Lichtkollektor (38) mit dem Umfangsrand der Verstrebung (32) so verbunden ist, dass das von der Hauptlichtquelle (36) ausgegebene Licht in die Dicke der Verstrebung (32) eindringt.

4. Bedienfeld (10) nach dem vorangehenden Anspruch, **dadurch gekennzeichnet, dass** der Kollektor (38) aus einem angesetzten Teil besteht, das zwischen der Hauptlichtquelle (36) und der Verstrebung (32) eingesetzt ist.

5. Bedienfeld (10) nach Anspruch 3, **dadurch gekennzeichnet, dass** der Kollektor (38) mit der Verstrebung (32) aus einem Stück gebildet ist.

6. Bedienfeld (10) nach einem der vorangehenden Ansprüche, **dadurch gekennzeichnet, dass** die Verstrebung (32) vollständig aus lichtdurchlässigem Material, beispielsweise vom Typ Silikon, hergestellt ist.

7. Bedienfeld (10) nach einem der vorangehenden Ansprüche, **dadurch gekennzeichnet, dass** dem Erfassungsbereich (Z1) eine Kontrollleuchte (T1) zugeordnet ist und dazu vorgesehen ist, von einer Hilfslichtquelle (46) durch den Sensor (18) hindurch hinterleuchtet zu werden, wobei der empfindliche Bereich (30) des Sensors (18) einen Durchtrittsbereich (32) zum Durchtritt von Licht eingrenzt, das die Hinterleuchtung der Kontrollleuchte gestattet.

8. Bedienfeld (10) nach einem der vorangehenden Ansprüche, **dadurch gekennzeichnet, dass** der Kraftsensor (18) ein erstes (20) und ein zweites (22) Substrat aufweist, von denen zumindest eines dann biegsam ist, wenn eine Berührungskraft auf den Erfassungsbereich (Z1) ausgeübt wird, wobei Leiterbahnen (24, 26) und eine Widerstandsbeschichtung (28) zwischen den beiden Substraten (20, 22) so angeordnet sind, dass sie einen druckempfindlichen Bereich (30) definieren, der es dem Sensor (18) gestattet, die Berührungskraft über eine Änderung des elektrischen Widerstands zwischen den Leiterbahnen (24, 26) durch die Widerstandsbeschichtung (28) hindurch zu erfassen, um das Steuersignal zu erzeugen.

9. Bedienfeld (10) nach einem der vorangehenden Ansprüche, **dadurch gekennzeichnet, dass** der Sensor (18) vorgespannt ausgeführt ist, wobei die Widerstandsbeschichtung (28) dazu vorgesehen ist, mit den Leiterbahnen (24, 26) elektrisch in Kontakt zu gelangen, einschließlich bei ausbleibender Berührung, wobei die Vorspannung von der Verstrebung (32) sichergestellt wird.

10. Bedienfeld (10) nach einem der vorangehenden Ansprüche, **dadurch gekennzeichnet, dass** es mehrere Erfassungsbereiche (Z1) aufweist, die mehrere Steuertasten (B1) bilden, denen mehrere Kraftsensoren (18) zugeordnet sind, dass die den verschiedenen Erfassungsbereichen (Z1) zugeordneten Verstrebungen (32) miteinander aus einem Stück gebildet sind, um eine Platte zu bilden, und dass die Hauptlichtquelle (36) mehrere Verstrebungen (32) der Platte ausleuchtet.

11. Bedienfeld (10) nach einem der vorangehenden Ansprüche, **dadurch gekennzeichnet, dass** die Hauptlichtquelle (36) dazu vorgesehen ist, Licht in zumindest zwei unterschiedlichen Farben auszugeben, so dass der aktivierte Zustand sowie der deaktivierte Zustand der zugeordneten Steuertaste (B1) identifiziert werden kann.

12. Bedienfeld (10) nach einem der vorangehenden Ansprüche, **dadurch gekennzeichnet, dass** der auszuleuchtende Bereich (S1) des Erfassungsbereichs (Z1) aus einem lichtdurchlässigen Zeichen besteht, das auf die Abdeckung (12) aufgezeichnet ist.

## Claims

1. Control panel (10), in particular for a motor vehicle, including a cover (12) which is provided with at least one detection zone (Z1) of a tactile pressing forming a control button (B1), in which a force sensor (18) is arranged between the cover (12) and a support (14), behind the detection zone (Z1), so as to detect the actuation of the control button (B1) to produce an electrical control signal when a user applies a determined tactile pressing force to the detection zone (Z1), in which a spacer (32) made of elastically compressible material is mounted between the sensor (18) and the cover (12) so as to take up the mechanical plays between the sensor (18) and the cover (12), the spacer (32) being at least partially translucent and the control panel (10) including at least one main light source (36) and a light collector (38) which permits injection of the light produced by the said main light source (36) into the thickness of the spacer (32) so that the spacer (32) produces a backlighting beam directed towards a zone to be illuminated (S1) of the detection zone (Z1), the main light source (36) being arranged on a printed circuit board (40) which is fixed behind the support (14) on the side opposite to the force sensor (18), **characterised by** the fact that a portion of the collector (38) extends in a through hole (42) formed in the thickness of the support (14) opposite the main light source (36).

2. Control panel (10) as described in the preceding claim, **characterised by** the fact that the zone to be illuminated (S1) is arranged facing the pressure-sensitive zone (30) of the force sensor (18) and by the fact that the main light source (36) is offset transversally relative to the zone to be illuminated (S1).

3. Control panel (10) as described in any one of the preceding claims, **characterised by** the fact that the light collector (38) is connected to the peripheral edge of the spacer (32) so that the light emitted by the main light source (36) penetrates the thickness of the spacer (32).

4. Control panel (10) as described in the preceding claim, **characterised by** the fact that the collector (38) is formed by an attached piece which is interposed between the main light source (36) and the spacer (32).

5. Control panel (10) as described in claim 3, **characterised by** the fact that the collector (38) is made in one piece with the spacer (32).

6. Control panel (10) as described in any one of the preceding claims, **characterised by** the fact that the spacer (32) is entirely made of translucent material, for example of the silicone type.

7. Control panel (10) as described in any one of the preceding claims, **characterised by** the fact that a luminous tell-tale (T1) is associated with the detection zone (Z1) and is designed to be backlit by an auxiliary light source (46) through the sensor (18), the sensitive zone (30) of the sensor (18) defining a zone for passage of the light (32) permitting backlighting of the luminous tell-tale.

8. Control panel (10) as described in any one of the preceding claims, **characterised by** the fact that the force sensor (18) includes a first (20) and a second (22) substrate at least one of which is flexible when a tactile pressing force is applied to the detection zone (Z1), conductive tracks (24, 26) and a resistive coating (28) being arranged between the two substrates (20, 22) so as to define a pressure-sensitive zone (30) which allows the sensor (18) to detect the tactile pressing force by a variation of the electrical resistance between the conductive tracks (24, 26) through the resistive coating (28) to produce the control signal.

9. Control panel (10) as described in the preceding claim, **characterised by** the fact that the sensor (18) is of the prestressed type, the resistive coating (28) being designed to be in electrical contact with the conductive tracks (24, 26) including in the absence of tactile pressing, the prestressing being provided by the spacer (32).

10. Control panel (10) as described in any one of the preceding claims, **characterised by** the fact that it includes a plurality of detection zones (Z1) forming a plurality of control buttons (B1) associated with a plurality of force sensors (18), by the fact that the spacers (32) associated with the different detection zones (Z1) are made in one piece the ones with the others to form a plate, and by the fact that the main light source (36) lights a plurality of spacers (32) of the plate.

11. Control panel (10) as described in any one of the preceding claims **characterised by** the fact that the main light source (36) is designed to emit light in two distinct colours so as to allow identification of the activated state and of the deactivated state of the associated control button (B1).

12. Control panel (10) as described in any one of the preceding claims, **characterised by** the fact that the zone to be illuminated (S1) of the detection zone (Z1) is formed by a translucent symbol drawn on the cover (12).
